# EUROPÄISCHE PATENTSCHRIFT

(11) **EP 0 984 675 B1**
(45) Veröffentlichungstag und Bekanntmachung des Hinweises auf die Patenterteilung: **13.10.2004**
(21) Anmeldenummer: 99106485.8
(22) Anmeldetag: 30.03.1999
(51) Int. Cl.: H05K 13/04, H05K 13/00

(54) **Vorrichtung zur mechanischen Ausrichtung eines Trägersubstrats für elektronische Schaltungen**
Apparatus for aligning a support for electronic circuits
Dispositif pour aligner un support pour des circuits électroniques

(30) Priorität: 02.07.1998 DE 19829580
(43) Veröffentlichungstag der Anmeldung: 08.03.2000
(73) Patentinhaber: ROBERT BOSCH GMBH, 70442 Stuttgart (DE)
(72) Erfinder: Becker, Klaus, 72810 Gormaringen (DE); Armbruster, Eugen, 72124 Pliezhausen (DE)

(56) Entgegenhaltungen:
- DE-A- 2 440 088

## Beschreibung

### Stand der Technik

Die Erfindung betrifft eine Vorrichtung zur mechanischen Ausrichtung eines Trägersubstrats für elektronische Schaltungen mit den im Oberbegriff des Anspruchs 1 angegebenen Merkmalen.

Bei der Verarbeitung von Trägersubstraten für elektronische Schaltungen, wie beispielsweise Leiterplatten oder Keramiksubstraten, werden die Trägersubstrate in den einzelnen Verarbeitungsstationen in bezug auf eine vorher festgelegte Position ausgerichtet. Um zum Beispiel Leiterbahnen oder Bauelemente an den dafür vorgesehenen Positionen auf die Trägersubstrate aufzubringen, werden die Trägersubstrate in der Aufnahme einer Siebdruckstation zum Aufdrucken von Leiterbahnen oder in der Aufnahme eines Bestückers zur Aufbringung von elektrischen und/oder elektronischen Bauelementen vor der Bearbeitung mechanisch ausgerichtet. Zu diesem Zweck ist bekannt, Vorrichtungen zur Ausrichtung eines Trägersubstrats zu verwenden, welche mehrere Zentrierelemente aufweisen, die an der Umfangsfläche des Trägersubstrats zur Anlage gebracht werden und das Trägersubstrat in die gewünschte Bearbeitungsposition verschieben. Die Zentrierelemente sind in der Vorrichtung mit einer Verstelleinrichtung zum Trägersubstrat verstellbar und können unter Federvorspannung an der Umfangsfläche des Trägersubstrats zur Anlage gebracht werden. Dadurch, daß die Zentrierelemente mittels federelastischer Spannkraft gegen die Umfangsfläche des Trägersubstrats gedrückt werden, wird vermieden, daß die Trägersubstrate, deren Größe innerhalb bestimmter Toleranzen schwankt, bereits beim Anschlag der Zentrierelemente beschädigt werden.

Als nachteilig bei diesen bekannten Vorrichtungen muß angesehen werden, daß bei relativ spröden Trägersubstraten, wie beispielsweise keramischen Mehrlagensubstraten und insbesondere bei keramischen LTCC-Substraten, die Substratkanten an den Stellen, an welchen die Zentrierelemente zur Anlage gelangen, oft muschelförmig ausbrechen und in einigen Fällen die Trägersubstrate zerbrechen. Dies ist darauf zurückzuführen, daß die Reibung zwischen den Anschlagflächen der Zentrierelemente und der Umfangsfläche der Trägersubstrate relativ groß ist und die Zentrierelemente nicht entlang der Umfangsfläche des Trägersubstrats beweglich sind, sondern nur zur Umfangsfläche hin- bzw. davon wegbewegbar sind. Aus diesem Grund kann nicht ausgeschlossen werden, daß sich das Trägersubstrat zwischen den Zentrierelementen verkantet. Bei der Bearbeitung des Trägersubstrats kann daher eine kurze ruckartige Bewegung des Trägersubstrats, die beispielsweise durch einen an der Unterseite des Trägersubstrats angelegten Unterdruck oder durch die Druckkraft eines SMD-Bestückers hervorgerufen wird, zum Bruch des spröden Trägersubstrats führen. Außerdem ist nachteilig, daß die Reibung des Trägersubstrats an den Anschlagflächen der Zentrierelemente zu einem frühzeitigen Verschleiß der Zentrierelemente führt, was wiederum eine ungenaue Ausrichtung der Trägersubstrate und Bruchkanten an der Umfangsfläche der Trägersubstrate zur Folge haben kann.

### Vorteile der Erfindung

Durch die erfindungsgemäße Vorrichtung zur Ausrichtung eines Trägersubstrats für elektronische Schaltungen mit den kennzeichnenden Merkmalen des Anspruchs 1 werden die beim Stand der Technik auftretenden Nachteile vermieden. Mit der erfindungsgemäßen Vorrichtung wird vorteilhaft erreicht, daß ein Entlangreiben der Anschlagfläche der Zentrierelemente an der Umfangsfläche des Trägersubstrats vermieden wird, wenn beispielsweise die Zentrierelemente das Trägersubstrat in die vorbestimmte Position verschieben oder wenn sich das Trägersubstrat in einer Richtung senkrecht zur horizontalen Aufnahme der Vorrichtung bewegt. Ein Ausmuscheln oder Brechen von spröden Trägersubstraten wird hierdurch vorteilhaft vermieden. Da in den Verarbeitungsstationen für Trägersubstrate in der Regel eine Krafteinleitung senkrecht zu den Hauptoberflächen des Trägersubstrats gerichtet ist, ist besonders vorteilhaft, daß durch die spezielle Anordnung der Zentrierelemente eine Ausgleichbewegung aller an der Umfangsfläche des Trägersubstrats anliegenden Zentrierelemente durch Drehung oder Verschiebung in dieser Richtung möglich ist, ohne daß mechanische Spannungen in dem Trägersubstrat entstehen. Vorteilhaft ist weiterhin, daß durch die Beweglichkeit der an dem Trägersubstrat anliegenden Zentrierelemente ein reibungsbedingter frühzeitiger Verschleiß der Zentrierelemente vermieden werden kann und die Lebensdauer der Vorrichtung vergrößert wird.

Vorteilhafte Ausgestaltungen und Weiterbildungen der Erfindung werden durch die in den Unteransprüchen enthaltenen Merkmale ermöglicht. Vorteilhaft ist, wenn die wenigstens zwei weiteren Zentrierelemente auf wenigstens zwei zueinander parallelen und senkrecht zu der horizontalen Aufnahme verlaufenden zweiten Achsen drehbar und in Achsrichtung verschiebbar gelagert sind. Hierdurch wird nicht nur erreicht, daß die Anschlagflächen dieser Zentrierelemente senkrecht zur horizontalen Aufnahme der Trägersubstrate beweglich sind, sondern daß sich die Zentrierelemente darüber hinaus durch eine Drehbewegung um die zweiten Achsen optimal an die sich gegenüberliegenden Abschnitte der Umfangsfläche des Trägersubstrats anlegen, selbst dann wenn diese Abschnitte nicht völlig eben sind, was bei keramischen LTCC-Substraten häufig der Fall ist.

Vorteilhaft ist, wenn die ersten Achsen in einer Ebene unterhalb einer durch die horizontale Aufnahme definierten Ebene auf ihrer jeweiligen Verstelleinrichtung montiert sind, wenn auf den Verstelleinrichtungen wenigstens jeweils ein Anschlagelement angeordnet ist, und wenn durch die Anlage des auf der jeweiligen ersten Achse gelagerten Zentrierelementes an der Umfangsfläche des Trägersubstrats das Zentrierelement gegen eine Anschlagfläche des Anschlagelement angedrückt wird. Auf diese Weise wird erreicht, daß sich die auf den ersten Achsen drehbar gelagerten Zentrierelemente nicht bereits bei Anlage an der Umfangsfläche des Trägersubstrats verdrehen können; jedoch können sich die Zentrierelemente weiterhin in entgegengesetzter Richtung drehen, falls sich das Trägersubstrat zur Aufnahme hin bewegt. Eine Reibung zwischen dem jeweiligen Zentrierelement und der Anschlagfläche des Anschlagelemente bei einer Verschiebung des Zentrierelementes auf der ersten Achse kann vorteilhaft dadurch vermieden werden, daß die Anschlagfläche des wenigstens einen Anschlagelementes in der zweiten Richtung beweglich gelagert ist. Dies kann auf sehr einfache Weise dadurch realisiert werden, daß das wenigstens eine Anschlagelement durch eine zylinderförmige Rolle gebildet wird, die um eine senkrecht zur der Aufnahme verlaufende Achse an der jeweiligen Verstelleinrichtung drehbar gelagert ist, wobei die Anschlagfläche durch die Mantelfläche der zylinderförmigen Rolle gebildet wird.

Weiterhin ist vorteilhaft, wenn die an der Umfangsfläche eines Trägersubstrats anliegenden Zentrierelemente entgegen der Spannkraft eines Federelements auf der jeweiligen Achse drehbar und entgegen der Spannkraft eines Federelementes verschiebbar angeordnet sind. Hierdurch wird vorteilhaft erreicht, daß die Zentrierelemente bei Entnahme des Trägersubstrat aus der Aufnahme der Vorrichtung durch die Spannkraft der Federn in eine definierte Ausgangslage oder Ruhelage bewegt werden, in der sie zur Zuführung eines neuen Trägersubstrats bereit sind.

Vorteilhaft ist weiterhin, wenn die Zentrierelemente eine ebene Anschlagfläche aufweisen, welche an der Umfangsfläche des Trägersubstrats zur Anlage gelangt. Da Keramiksubstrate für elektronische Schaltungen in der Regel die Form einer rechteckförmigen dünnen Platte aufweisen, können die Zentrierelemente mit den ebenen Anschlagflächen an den die Umfangsfläche bildenden Stirnflächen der Keramiksubstrate sicher zur Anlage gelangen.

Vorteilhaft ist, wenn die Zentrierelemente mittels jeweils eines Kugellagers auf den Achsen drehbar und verschiebbar gelagert sind, da hierdurch die Lebensdauer der Vorrichtung vergrößert wird.

Weiterhin ist vorteilhaft, wenn die Zentrierelemente der Vorrichtung nacheinander an der Umfangsfläche eines Trägersubstrats derart zur Anlage gebracht werden, daß eines der wenigstens zwei weiteren Zentrierelemente, deren Anschlagflächen senkrecht zur horizontalen Aufnahme beweglich gelagert sind, zuletzt an der Umfangsfläche zur Anlage gelangt. Hierdurch wird in vorteilhafter Weise erreicht, daß das Trägersubstrat nicht vor der Anlage der in horizontaler Richtung verschiebbaren Zentrierelemente zwischen den in horizontaler Richtung nicht verschiebbaren weiteren Zentrierelementen eingeklemmt wird.

### Zeichnung

Ein Ausführungsbeispiel der Erfindung ist in den Zeichnungen dargestellt und wird in der nachfolgenden Beschreibung näher erläutert. Es zeigt
Fig. 1 eine perspektivische und schematische Ansicht einer erfindungsgemäßen Vorrichtung zur Ausrichtung von Trägersubstraten,
Fig. 2 einen Querschitt durch ein einzelnes Zentrierelement und dessen Verstelleinrichtung,
Fig. 3 einen Querschnitt durch ein Kugellager eines einzelnen Zentrierelementes.

### Beschreibung der Ausführungsbeispiele

Trägersubstrate für elektronische Schaltungen, wie beispielsweise keramische Multilayer oder LTCC-Keramiken, werden in speziellen, an sich bekannten Verarbeitungsstationen mit elektronischen Schaltungsteilen versehen. Solche Verarbeitungsstationen sind beispielsweise Siebdruckstationen zum Aufdrucken von Leiterbahnen auf die Trägersubstrate, SMD-Bestücker zur Aufbringung von SMD-Bauelementen auf die Hauptoberflächen der Trägersubstrate, Lotpastendruckstationen zur Aufbringung von Lotpaste oder Kleberstationen zur Auftragung von Kleber für die SMD-Bauelemente. Alle diese bekannten Verarbeitungsstationen, von denen hier nur einige genannt sind, machen eine Ausrichtung des Trägersubstrats für die nachfolgende Bearbeitung notwendig, damit die elektrischen und elektronischen Bauelemente und Leiterbahnen exakt auf den Trägersubstraten aufgebracht werden können.

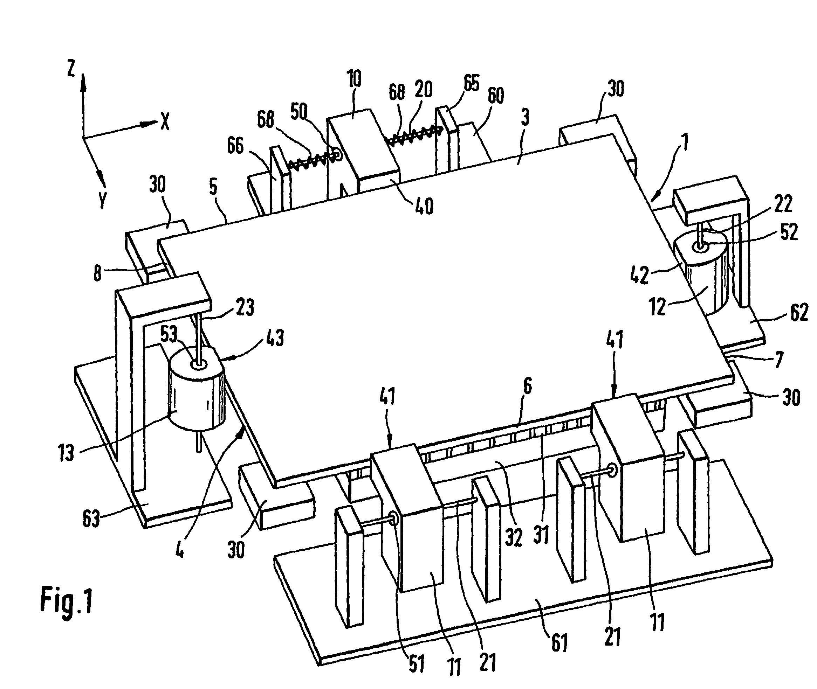

Fig. 1 zeigt ein erstes Ausführungsbeispiel einer Vorrichtung zur Ausrichtung eines Trägersubstrats, welche in eine Verarbeitungsstation für Trägersubstrate, beispielsweise in eine Siebdruckstation für LTCC-Keramiken, eingebaut werden kann. Solche Teile der Vorrichtung, welche für das Verständnis der Erfindung nicht notwendig erforderlich sind, sind der Einfachheit halber nicht dargestellt. Wie in Fig. 1 zu erkennen ist, umfaßt die Vorrichtung eine horizontale Aufnahme 30,31 für ein der Siebdruckstation zur Bearbeitung zugeführtes Trägersubstrats 1. Die Aufnahme 30,31 umfaßt vier in einer gemeinsamen horizontalen Ebene liegende Auflageflächen 30 und eine in dieser Ebene liegende Lochplatte 31. Die Auflageflächen 30 und die Lochplatte 31 bilden gemeinsam eine horizontale Aufnahmefläche für das Trägersubstrat. Unterhalb der Lochplatte 31 ist eine Unterdruckvorrichtung 32 angeordnet. Weiterhin umfaßt die hier gezeigte Vorrichtung fünf Zentrierelemente 10 bis 13, welche auf jeweils einer Achse 20 bis 23 drehbar und verschiebbar gelagert sind und welche aus gehärtetem Edelstahl gefertigt sind.

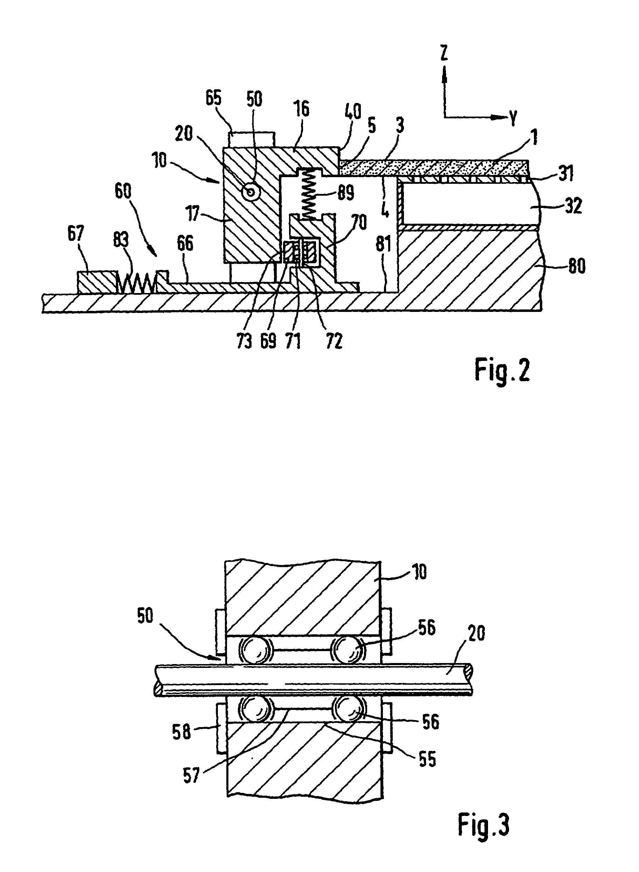

Wie in Fig. 1 und Fig. 2 dargestellt, ist ein Zentrierelement 10 um eine erste Achse 20 drehbar und gleichzeitig auf dieser ersten Achse 20 verschiebbar gelagert. Die erste Achse 20 ist parallel zu der durch die horizontale Aufnahmefläche 30,31 der Vorrichtung definierten Ebene auf einer Verstelleinrichtung 60 montiert. Wie in Fig. 2 zu erkennen ist, ist in dem hier gezeigten Ausführungsbeispiel die erste Achse 20 etwas unterhalb der durch die horizontale Aufnahmefläche 30,31 definierten Ebene angeordnet. Das auf der ersten Achse 20 gelagerte Zentrierelement 10 weist eine L-förmige Form mit einem ersten Schenkel 16 und einem davon senkrecht abstehenden zweiten Schenkel 17 auf. Das von dem zweiten Schenkel 17 abgewandte Ende des ersten Schenkels 16 ist mit einer ebenen Anschlagfläche 40 zur Anlage an der Umfangsfläche des Trägersubstrats 1 versehen. Das Zentrierelement 10 ist bei dem hier gezeigten Ausführungsbeispiel über ein in dem zweiten Schenkel 17 angeordnetes Kugellager 50 mit Käfigführung auf der Achse 20 drehbar und verschiebbar gelagert. Das Kugellager 50 ist in Fig. 3 genauer dargestellt. Das an sich bekannte Kugellager 50 ist in Art einer Kugelbuchse so aufgebaut, daß die Kugeln 56 in einer zylinderförmigen Ausnehmung 55, welche parallel zu der Achse 20 in dem Zentrierelement 10 angeordnet ist, zwischen der Achse 20 und der Innenwandung der zylinderförmigen Ausnehmung angeordnet sind und direkt auf der Achse 20 abrollen. Eine Käfigführung 57 dient zur Führung der Kugeln 56 bei einer Drehung oder Verschiebung des Zentrierelementes 10 und zur Festlegung der Lage der Kugeln 56 innerhalb der Ausnehmung 55. Eine Abdeckung 58 verhindert, daß die Kugeln 56 aus der zylinderförmigen Ausnehmung 55 herausfallen. Bei der Verwendung des beschriebenen Kugellagers 50 mit Käfigführung ist gewährleistet, daß das Zentrierelement 10 auf der Achse 20 verschiebbar ist und gleichzeitig um diese Achse drehbar ist. Es ist aber auch denkbar, an Stelle des Kugellagers 50 ein Gleitlager oder ein anderes Lager zu verwenden. Wichtig ist, daß das Zentrierelement 10 sowohl verschiebbar als auch drehbar auf der Achse 20 gelagert ist.

Wie in Fig. 1 und Fig. 2 weiterhin dargestellt ist, sind die Enden der ersten Achse 20 an zwei senkrecht zur Auflagefläche 30,31 verlaufenden Stegen 65,66 der Verstelleinrichtung 60 befestigt. Die beiden Stege 65,66 sind auf einen Schlitten 66 montiert, welcher über einen Motor mit Antriebseinheit entlang der in Fig. 1 und Fig. 2 mit y gekennzeichneten Richtung bewegt werden kann. Soweit nichts anderes gesagt ist, wird im folgenden unter y-Richtung immer sowohl die positve als auch die negative y-Richtung mit gegenläufigem Richtungssinn verstanden. Wie am besten in Fig. 2 zu erkennen ist, ist der Schlitten 66 auf einer Schiene 81 in y-Richtung beweglich angeordnet. Die Schiene 81 ist auf einem feststehenden Sockelteil 80 der Vorrichtung angeordnet. Der Schlitten 66 ist über eine Federelement 83 mit einem in y-Richtung beweglichen Führungsteil 67 der Verstelleinrichtung 60 verbunden. Auf dem Schlitten 66 der Verstelleinrichtung 60 ist weiterhin ein Anschlagelement 69 vorgesehen. Das Anschlagelement 69 weist die Form einer zylinderförmigen Rolle auf, die um eine senkrecht zu der Aufnahme 30,31 verlaufende Achse 72 drehbar an einer mit dem Schlitten 66 verbundenen Haltevorrichtung 70 montiert ist. Die Rolle 69 ist über ein Kugellager 71 mit Käfigführung auf der Achse 72 drehbar angeordnet. Die äußere Mantelfläche 73 der zylinderförmigen Rolle bildet eine Anschlagfläche für das Zentrierelement 10 aus. In einer Position der Verstelleinrichtung, in welcher das Zentrierelement 10 noch nicht an dem Trägersubstrat 1 anliegt, ragt der zweite Schenkel 17 in etwa senkrecht zur Aufnahmefläche 30,31 nach unten, während der erste Schenkel 18 in etwa parallel zu der horizontalen Aufnahmefläche 30,31 orientiert ist und mit der Anschlagfläche 40 zum Trägersubstrat hinweist. In dieser Position liegt der Schenkel 17 des Zentrierelementes 10, wie in Fig. 2 gezeigt, an der Anschlagfläche 73 des Anschlagelementes 69 an. Ein an dem ersten Schenkel 16 angreifendes Federelement 89, welches sich gegen die Oberseite der Haltevorrichtung 70 abstützt, drückt mit einer relativ schwachen Federspannkraft den Schenkel 17 an das Anschlagelement 69 an, um eine Verdrehung des Zentrierelement 10 aus der in Fig. 2 gezeigten Ausgangsposition bei Nichtanlage an dem Trägersubstrat 1 zu vermeiden.

Zur Zentrierung eines Trägersubstrats 1 verstellt eine nicht dargestellte Antriebseinheit das Führungsteil 67 in Fig. 2 nach rechts, wodurch über das Federelement 83 der Schlitten 66 ebenfalls nach rechts verschoben wird. Der Schlitten 66 wird solange verschoben, bis das Zentrierelement 10 mit seiner ebenen Anschlagfläche 40 an einem Abschnitt 5 der Umfangsfläche des Trägersubstrats 1 in der in Fig. 2 gezeigten Position zur Anlage gelangt. Sobald das Zentrierelement 10 an der Umfangsfläche des Trägersubstrats zur Anlage gelangt, wirkt ein Drehmoment auf das Zentrierelement 10 ein, wodurch das Zentrierelement in Fig. 2 entgegen dem Uhrzeigersinn mit dem Schenkel 17 an das Anschlagelement 69 angedrückt wird. Das Anschlagelement 69 verhindert dabei, daß sich das Zentrierelement 10 entgegen dem Uhrzeigersinn auf der Achse 20 verdreht. Bei der weiteren Bewegung des Schlittens 66 nach rechts, wird das Trägersubstrat 1 nun auf der Aufnahmefläche 30,31 nach recht verschoben. Wie weiter unten noch ausführlicher dargestellt wird, gelangen an dem Abschnitt 6 der Umfangsfläche des Trägersubstrats 1, welcher dem Abschnitt 5 gegenüberliegt, ebenfalls Zentrierelemente 11 im entgegengesetzten Richtungssinn (d.h. in negativer y-Richtung) zur Anlage. Sobald daher die Zentrierelemente 11 an dem gegenüberliegenden Abschnitt 6 der Umfangsfläche des Trägersubstrat 1 zur Anlage gelangt, wird in Fig. 2 durch eine weitere Verstellbewegung des Führungsteils 67 in y-Richtung das Federelement 83 solange vorgespannt, bis das Führungteil 67 der Verstelleinrichtung 60 seine durch die Antriebseinheit vorgegebene Endlage erreicht. Das Zentrierelement 10 wird nun in der Endposition durch die Federvorspannkraft des Federelementes 83 an die Umfangsfläche des Trägersubstrats 1 angedrückt. Bei der Entfernung des Zentrierelementes 10 von dem Trägersubstrat wird genau umgekehrt verfahren. Das Führungsteil 67 wird in Fig. 2 nach links bewegt, wodurch sich der mit dem Führungsteil 67 über das Federelement 83 verbundene Schlitten 66 ebenfalls nach links bewegt und das Zentrierelement 10 von dem Trägersubstrat wegbewegt. Das hier dargestellte Ausführungsbeispiel der Verstelleinrichtung 60 ist nur eine Möglichkeit das Zentrierelement 10 unter Federvorspannung am Trägersubstrat zur Anlage zu bringen. Natürlich sind auch andere Ausgestaltungen der Verstelleinrichtung denkbar. Beispielsweise kann das Federelement 83 eine Schraubenfeder, eine Blattfeder, ein federelastisches Gummi oder ein anderes beliebiges Federelement sein. Auch sind andere Ausführungen denkbar, bei denen die Achse 20 des Zentrierelementes 10 nicht auf einem Schlitten, sondern auf einer andersartig ausgestalteten Zuführeinrichtung montiert ist. Wichtig ist, daß das Zentrierelement 10 in y-Richtung zum Trägersubstrat hin- bzw. vom Trägersubstrat weg verstellbar ist. Wie in Fig. 1 dargestellt ist, sind weiterhin zwei als Schraubenfedern ausgebildete Federelemente 68 vorgesehen, welche auf die Achse 20 aufgeschoben sind und sich mit ihrem jeweils ersten Ende an einem der beiden Stege 65, 66 und mit ihrem jeweils zweiten Ende an dem Zentrierelement 10 abstützen. Wie noch weiter unten beschrieben wird, dienen die Federelemente 68 dazu, daß Zentrierelement 10 bei einer während der Ausrichtung des Trägersubstrats 1 erfolgten Verschiebung auf der Achse 20 nach der Entnahme des Trägersubstrats aus der Vorrichtung wieder in seine Ausgangslage zurückzuschieben.

Wie in Fig. 1 weiterhin zu erkennen ist, sind in dem hier dargestellten Ausführungsbeispiel zwei Zentrierelemente 11, welche gleichartig zu dem Zentrierelement 10 aufgebaut sind, in einer dem Zentrierelement 10 in bezug auf die Aufnahme 30,31 gegenüberliegenden Position angeordnet. Die Zentrierelemente 11 sind auf je einer ersten Achse 21 über Kugellager 51 in gleicher Weise wie das Zentrierelemente 10 drehbar und verschiebbar gelagert. Die ersten Achsen 21 sind parallel zu der ersten Achse 20 und parallel zu der horizontalen Aufnahmefläche 30,31 auf Höhe der Achse 20 angeordnet. Das heißt, die ersten Achsen 20 und 21 sind in einer Ebene unterhalb und parallel zu der durch die Aufnahmefläche 30,31 definierten Ebene angeordnet. Es wäre aber auch denkbar, die ersten Achsen in der Ebene der Aufnahmefläche anzuordnen. Wichtig ist, daß die Achsen 20,21 so angeordnet sind, daß bei Anlage der Zentrierelemente 10,11 an dem Trägersubstrat kein Drehmoment entsteht, welches die Zentrierelemente 10,11 von den Anschlagelementen wegdreht. Weiterhin können die beiden Zentrierelemente 11 auch auf nur einer Achse 21 angeordnet sein. Die Achsen 21 sind wie die Achse 20 auf einem Schlitten einer Verstelleinrichtung 61 montiert und können mit diesem ebenfalls in y-Richtung zur Aufnahmefläche hin und weg bewegt werden. Die Verstelleinrichtung 61 ist wie die Verstelleinrichtung 60 aufgebaut und mit rollenförmigen Anschlagelementen für die Zentrierelemente 11 und mit Federelementen versehen, welche die Zentrierelemente 11 an den Anschlagelementen zur Anlage bringen. Bei der Verstelleinrichtung 61 kann im Unterschied zu der in Fig. 2 gezeigten Verstelleinrichtung 60 gegebenenfalls das Federelement 83 entfallen, welches das Zentrierelement 11 gegen die Umfangsfläche des Trägersubstrats andrückt. Da die Zentrierelemente 10 und 11 an gegenüberliegenden Abschnitten des Trägersubstrats zur Anlage gelangen, wird durch die Spannkraft des Federelementes 83 der Verstelleinrichtung 60 dann sowohl das Federelement 10 als auch die Federelemente 11 gegen die Umfangsfläche des Trägersubstrates angedrückt. Weiterhin sind die Zentrierelemente 11 wie das Zentrierelement 10 entgegen der Spannkraft von auf auf den Achsen 21 angeordneten, in Fig. 1 nicht dargestellten Federelementen, verschiebbar angeordnet. In einem anderen Ausführungsbeispiel kann auch vorgesehen sein, nur ein Zentrierelement 11 vorzusehen, welches dann dem Zentrierelement 10 in Bezug auf die Aufnahme 30,31 gegenüberliegt. Natürlich ist es auch denkbar, zwei Zentrierelemente 10 auf der Achse 20 anzuordnen und zwei Zentrierelemente 11 auf der Achse 21 anzuordnen. Darüber hinaus sind auch weitere Möglichkeiten der Anordnung der Zentrierelemente 10 und 11 denkbar.

Wie in Fig. 1 dargestellt ist, umfaßt die Vorrichtung weiterhin zwei weitere Zentrierelemente 12,13, die auf jeweils einer zweiten Achse 22,23 verschiebbar und um diese Achse in gleicher Weise wie die Zentrierelemente 10 und 11 drehbar gelagert sind. Die zweiten Achsen 22,23 sind parallel zueinander angeordnet und verlaufen senkrecht zu der Aufnahmefläche 30,31. Die weiteren Zentrierelemente 12,13 weisen die Form eines Zylinders auf, dessen Mantelfläche an einer Seite abgeflacht ist. Die abgeflachten Seiten der Zylinder bilden ebene Anschlagflächen 42,43 zur Anlage an dem Trägersubstrat.

Das weitere Zentrierelement 12 ist auf einer der zweiten Achsen, welche in Fig. 1 mit der Bezugsziffer 22 gekennzeichnet ist, über ein Kugellager 52 mit Käfigführung drehbar und verschiebbar gelagert. Die Achse 22 und das Kugellager 52 durchdringen hierbei das zylinderförmige Zentrierelement 12 in axialer Richtung. Das zweite der weiteren Zentrierelemente, welches mit der Bezugsziffer 13 versehen ist, liegt dem Zentrierelement 12 in bezug auf die Aufnahmefläche 30,31 gegenüber und ist gleichartig zu diesem aufgebaut. Das Zentrierelement 13 ist auf einer zu der Achse 22 parallelen Achse 23 ebenfalls über ein Kugellager 53 mit Käfigführung drehbar und verschiebbar gelagert. Die zweiten Achsen 22,23 sind auf jeweils einer weiteren Verstelleinrichtung 62,63 gelagert, so daß die Zentrierelement 12,13 in x-Richtung zur Aufnahmefläche hin und davon weg verstellt werden können. Die weiteren Verstelleinrichtungen 62,63 umfassen ebenso wie die Verstelleinrichtungen 60,61 einen Schlitten, der über ein Federelement mit einem durch die Antriebseinheit angetriebenem Führungsteil der Verstelleinrichtungen verbunden ist. Bei Anlage der Zentrierelemente 12,13 an den Abschnitten 7,8 der Umfangsfläche des Trägersubstrats 1 werden die Zentrierelemente 11,12 durch die Spannkraft der mit den Schlitten verbundenen Federelemente gegen das Trägersubstrat angedrückt. Auch hier reicht es aus, wenn eine der weiteren Verstelleinrichtungen 62,63 mit einem Federelement, wie dem in Fig. 2 dargestellten Federelement 83 versehen ist.

Weiterhin sind in Fig. 1 nicht dargestellte Federelemente vorgesehen, welche analog zu den an dem Federelementen 10 und 11 angreifenden Federelementen 89 und 68 bei einer Drehung oder Verschiebung der Zentrierelemente 12 und 13 aus ihrer Ruhelage vorgespannt werden. Die Ruhelage der Zentrierelemente ist hierbei als eine Lage anzusehen, in welcher sich kein Trägersubstrat in der Aufnahme 30,31 befindet. Hierdurch wird erreicht, daß die Zentrierelemente 12,13 bei Entnahme des Trägersubstrats aus der Aufnahme der Vorrichtung in eine definierte Ausgangslage zurückbewegt werden und zur Zuführung eines neuen Trägersubstrats bereit sind. Die Federelemente können beispielsweise auf den Achsen 22 und 23 oder den weiteren Verstelleinrichtungen 62,63 befestigt sein.

Die keramischen Trägersubstrate 1 weisen in dem hier gezeigten Ausführungsbeispiel die Form rechteckförmiger dünner Platten mit einer ersten Hauptoberfläche 3 und einer dieser gegenüberliegenden zweiten Hauptoberfläche 4 und einer Umfangsfläche auf, welche durch vier schmale Stirn- oder Seitenflächen 5,6,7,8 gebildet wird. Die Trägersubstrate können aber auch andere Formen aufweisen, wie beispielsweise die Form einer kreisförmigen, keramischen Platte oder die Form einer rechteckförmigen Platte, aus der ein rechteckförmiger Ausschnitt entfernt wurde, oder andere Formen. Wie in Fig. 1 weiterhin zu erkennen ist, gelangt ein der Siebdruckstation zugeführtes Trägersubstrat 1, beispielsweise ein sprödes und bruchempfindliches LTCC-Substrat (Low Temperatur Cofired Ceramic), mit seiner nach unten weisenden Hauptoberfläche 4 an den Auflageflächen 30 und der Lochplatte 31 zur Anlage. Vor der Zuführung des Trägersubstrats 1 werden die Zentrierelemente 10,11,12 und 13 über die mit einer Antriebseinheit verbundenen Verstelleinrichtungen 60,61,62,63 von der Aufnahmefläche 30,31 in y- bzw. in x-Richtung entfernt, so daß eine problemlose Zuführung des Trägersubstrats 1 möglich ist. Dabei kann das Trägersubstrat 1 der Aufnahme 30,31 automatisch über ein Transportband zugeführt werden oder auch manuell eingelegt werden. Das auf der Aufnahmefläche 30,31 aufliegende Trägersubstrat 1 muß nun für den anschließenden Aufdruck der Leiterbahnen ausgerichtet werden. Zu diesem Zweck werden nun Zentrierelement 10 bis 13 in vorgegebener Reihenfolge an verschiedenen Abschnitten der Umfangsfläche 5,6,7,8 des Trägersubstrats zur Anlage gebracht. Dabei wird folgendermaßen verfahren. Zunächst werden die beiden Zentrierelemente 11 mit den Anschlagflächen 41 an der Seitenfläche 6 des Trägersubstrats 1 zur Anlage gebracht. Hierfür werden die Zentrierelemente 11 mit der Verstelleinrichtung 61 in negativer y-Richtung zum Trägersubstrat hin verschoben, bis sie sich in der vorgesehenen Endlage befinden. Anschließend wird das Zentrierelement 13 mit der Verstelleinrichtung 63 in x-Richtung zur Aufnahmefläche hin bewegt und gelangt mit seiner Anschlagfläche 43 an der Seitenfläche 8 des Trägersubstrats zur Anlage. Dabei dreht sich das Zentrierelement 13 so, daß die Anschlagfläche 43 parallel an der Seitenfläche 8 anliegt. Nun erst wird das Zentrierelement 10 mit der Verstelleinrichtung 60 zur Aufnahmefläche hin bewegt, bis es mit seiner Anschlagfläche 40 an der Seitenfläche 5 des Trägersubstrats, welche der Seitenfläche 6 gegenüberliegt, zur Anlage gelangt. Durch das Zentrierelement 10 wird das Trägersubstrat, wie bereits weiter oben dargestellt ist, in y-Richtung ausgerichtet. Bei der Zentrierung in y-Richtung kann es zu einer Drehbewegung des Trägersubstrats 1 in der horizontalen Ebene der Aufnahmefläche 30,31 kommen. Vorteilhaft ist hierbei, daß durch die Verschiebbarkeit bzw. das Entlanggleiten der Zentrierelemente 10 und 11 auf den ersten Achsen 20,21 vermieden wird, daß die Seitenflächen 5,6 des Trägersubstrats 1 bei einer Drehbewegung desselben an den Anschlagflächen 40,41 der Zentrierelemente entlanggleiten. Durch die dabei auftretende Reibung könnten mechanische Spannungen in dem Trägersubstrat 1 entstehen.

Schließlich wird als letztes das Zentrierelement 12 an der Seitenfläche 7 des Trägersubstrats zur Anlage gebracht und in seine Endlage geschoben, wodurch das Trägersubstrat 1 in x-Richtung ausgerichtet wird. Besonders vorteilhaft ist nun, daß bei Ausrichtung des Trägersubstrats in x-Richtung die bereits an dem Trägersubstrat anliegenden Zentrierelemente 10,11 auf den ersten Achsen 20,21 entlang der x-Richtung auf diesen Achsen verschoben werden können. Auf diese Weise wird eine Relativbewegung und eine daraus resultierende Reibung zwischen den Anschlägen 40,41 der Zentrierelemente 10,11 und den Seitenflächen 5,6 des Trägersubstrats vermieden.

Das Trägersubstrat 1 befindet sich nun in der gewünschten durch die Bewegung der Zentrierelemente 10 bis 13 in x-Richtung und in y-Richtung festgelegten Position. Die Zentrierelemente 10 bis 13 werden durch die Spannkraft der in den Verstelleinrichtungen 60 bis 63 integrierten Federelemente 83 gegen die Umfangsfläche des Trägersubstrats angedrückt, so daß das Trägersubstrat 1 zwischen den Zentrierelementen eingespannt ist. Mit der Unterdruckvorrichtung 32 wird nun über die Lochplatte 31 die untere Hauptoberfläche 4 des Trägersubstrats mit einem Unterdruck beaufschlagt, um das Trägersubstrat in der ausgerichteten Position zu fixieren bzw. festzuhalten. Da es vorkommen kann, daß das in x- und y-Richtung ausgerichtete Trägersubstrat 1 auf der Aufnahmefläche 30,31 noch nicht völlig eben aufliegt und noch etwas in z-Richtung geneigt ist oder nicht völlig eben ist, bewegt sich das Trägersubtrat 1 an einigen Stellen beim Einschalten des Unterdrucks in negativer z-Richtung und damit senkrecht zur horizontalen Aufnahmefläche 30,31. Vorteilhaft können sich nun die weiteren Zentrierelemente 12 und 13 auf den zweiten Achsen in z-Richtung verschieben, so daß eine Relativbewegung zwischen den Anschlagflächen 42,44 und den Abschnitten 7,8 der Umfangsfläche des Trägersubstrats vermieden wird.

Gleichzeitig können sich die Zentrierelemente 10 und 11 auf den ersten Achsen 20,21 um diese drehen und so einen Ausgleich in z-Richtung ermöglichen. Diese Drehbewegung sei am Beispiel des Zentrierelementes 10 in Fig. 2 erläutert. Bewegt sich der Abschnitt 5 der Umfangsfläche des Trägersubstrats in negativer z-Richtung, so dreht sich das Zentrierelement 10 in Fig. 2 im Uhrzeigersinn, wobei der Schenkel 17 des Zentrierelementes 10 durch die Drehbewegung vom Anschlagelement 69 entfernt wird. Das Zentrierelement dreht sich dabei entgegen der Spannkraft des Federelementes 89. Die Spannkraft des Federelementes 89 ist deshalb relativ schwach ausgebildet, so daß sie der Drehbewegung des Zentrierelementes 10 kaum entgegenwirkt. Weiterhin bildet bei der Drehung des Zentrierelementes 10 um die Achse 20 der Schenkel 16 einen Hebelarm aus, durch welchen eine in negativer y-Richtung gerichtete Kraft auf die Achse 20 einwirkt. Diese Kraft wird von der Achse 20 auf den Schlitten 66 übertragen und ist der Spannkraft des Federelementes 83 entgegengerichtet. Bei ausreichend großer Saugkraft der Unterdruckstation 32 wird daher der Schlitten 66 der Verstelleinrichtung 60 in negativer y-Richtung entgegen der Spannkraft des Federelementes 83 gegen das Führungsteil 67 zurückgedrückt. Gleichzeitig dreht sich das Zentrierelement 10 um die Achse 20, wobei sich die Anschlagfläche 40 des Zentrierelementes 10 an der Umfangsfläche 5 des Trägersubstrats quasi abrollt, bis das Trägersubstrat 1 eben an der Aufnahmefläche 30,31 anliegt. In gleichartiger Weise erfolgt die Drehbewegung der Zentrierelemente 11 um die Achsen 21. Beim Ansaugen des Trägersubstrats wird auf diese Weise auch eine Entlangreiben der Anschlagflächen 40,41 der Zentrierelemente 10 und 11 an der Umfangsfläche der Trägersubstrate und damit eine Beschädigung der spröden Trägersubstrate vermieden.

Wird nun das Trägersubstrat 1 durch den Unterdruck in der Aufnahmefläche 30,31 festgehalten, so können die Zentrierelemente 10,11,12,13 von der Umfangsfläche des Trägersubstrats entfernt werden. Dabei drehen und verschieben die schwachen Federelemente 89 und 68 die Zentierelemente 10 und 11 in ihre Ruhelage zurück. Dadurch, daß die Federelemente 89 und 68 relativ schwach ausgebildet sind, wird vermieden, daß es beim Zurückstellen der Zentrierelemente zu einem reibungsstarken Enlangreiben der Zentrierelemente an der Umfangsfläche und damit zu einer Beschädigung des Trägersubstrates kommt. Ebenso stellen in Fig. 1 nicht dargestellte Federelemente die weiteren Zentrierelemente 12 und 13 in ihre Ruhelage zurück. Nach dem Entfernen der Zentrierelemente 10,11,12,13 können dann in bekannter Weise Leiterbahnen auf die Hauptoberfläche 3 des Trägersubstrats 1 im Siebdruckverfahren aufgebracht werden.

Die hier beschriebene Vorrichtung ist keineswegs auf den Einsatz in Siebdruckstationen beschränkt. Sie ist beispielsweise genauso in einem SMD-Bestücker verwendbar, wobei die Zentrierelemente hierbei das Trägersubstrat auch während der Bearbeitung festhalten können, so daß die Haltevorrichtung 32 entfallen kann. Beim Absenken des Bestückungskopfes eines SMD-Bestückers kann der von dem Bestückungskopf auf eine der Hauptoberflächen des Trägersubstrats ausgeübte Druck in eine Relativbewegung des Trägersubstrats 1 senkrecht zur Aufnahmefläche resultieren. Auch in diesem Fall wird durch die erfindungsgemäße Vorrichtung eine Beschädigung der spröden Trägersubstrate durch ein Entlangreiben der Zentrierelemente an der Umfangsfläche des Trägersubstrats vermieden. Weiterhin sind auch andere Ausführungsbeispiele der erfindungsgemäßen Vorrichtung möglich, bei denen die in Fig. 1 dargestellten weiteren Zentrierelemente 12,13 beispielsweise nicht auf zwei senkrecht zu der horizontalen Aufnahme 30,31 verlaufenden Achsen gelagert sind, sondern auf zwei parallel zur der Aufnahme 30,31 in y-Richtung verlaufenden Achsen. Die Zentrierelemente 12,13 können dann wie die Zentrierelemente 10,11 aufgebaut sein. Ein Bruch des Trägersubstrats 1 bei einer Bewegung in z-Richtung wird dann nicht durch eine Verschiebung der Zentrierelemente 12,13 auf den Achsen 22,23 vermieden, sondern durch eine Drehung um diese Achsen. Bei diesem Ausführungsbeispiel können die weiteren Zentrierelement 12,13 dann beispielsweise analog zu den Zentrierelementen 10,11 aufgebaut sein.

## Patentansprüche

1. Vorrichtung zur Ausrichtung eines Trägersubstrats für elektronische Schaltungen, welches Trägersubstrat (1) zwei zueinander parallele Hauptoberflächen (3,4) und eine Umfangsfläche (5,6,7,8) aufweist und mit einer nach oben weisenden ersten Hauptoberfläche (3) einer horizontalen Aufnahme (30,31) der Vorrichtung zugeführt wird, wobei zur Ausrichtung des Trägersubstrats (1) in der horizontalen Aufnahme Zentrierelemente (10,11,12,13) durch jeweils eine Verstelleinrichtung (60,61,62,63) an der Umfangsfläche des Trägersubstrats (1) mittels Federspannkraft zur Anlage bringbar sind, welche Zentrierelemente (10,11,12,13) das Trägersubstrat in der Aufnahme in eine vorher festgelegte Position verschieben, **dadurch gekennzeichnet, daß** wenigstens zwei Zentrierelemente (10,11) auf je einer ersten Achse (20,21) drehbar und in Achsrichtung verschiebbar gelagert sind, welche ersten Achsen zueinander parallel und parallel zu der horizontalen Aufnahme (30,31) orientiert sind und durch jeweils eine Verstelleinrichtung (60,61) entlang einer ersten Richtung (±y) zum Trägersubstrat (1) verstellbar sind, wobei die Zentrierelemente (10,11) an in der ersten Richtung (±y) sich gegenüberliegenden Abschnitten (5,6) der Umfangsfläche des Trägersubstrats (1) mittels einer in der ersten Richtung (±y) wirksamen Federspannkraft zur Anlage bringbar sind, und daß wenigstens zwei weitere Zentrierelemente (12,13) durch jeweils eine weitere Verstelleinrichtung (62,63) entlang einer zur ersten Richtung (±y) senkrecht verlaufenden zweiten Richtung (±x) zum Trägersubstrat (1) verstellbar sind, welche weiteren Zentrierelemente (12,13) mittels einer in der zweiten Richtung (±x) wirksamen Federspannkraft an in der zweiten Richtung (±x) sich gegenüberliegenden Abschnitten (7,8) der Umfangsfläche des Trägersubstrats (1) mit Anschlagflächen (42,43) zur Anlage bringbar sind, welche Anschlagflächen (42,43) in einer Richtung (±z) senkrecht zur horizontalen Aufnahme (30,31) beweglich gelagert sind.

2. Vorrichtung nach Anspruch 1, **dadurch gekennzeichnet, daß** die wenigstens zwei weiteren Zentrierelemente (12,13) auf wenigstens zwei zueinander parallelen und senkrecht zu der horizontalen Aufnahme (30,31) verlaufenden zweiten Achsen (22,23) drehbar und in Achsrichtung verschiebbar gelagert sind.

3. Vorrichtung nach Anspruch 1, **dadurch gekennzeichnet, daß** die ersten Achsen in einer Ebene unterhalb einer durch die horizontale Aufnahme (30,31) definierten Ebene auf ihrer jeweiligen Verstelleinrichtung montiert sind, daß auf den Verstelleinrichtungen (60,61) wenigstens jeweils ein Anschlagelement (69) angeordnet ist, und daß durch die Anlage des auf der jeweiligen ersten Achse (20,21) gelagerten Zentrierelementes (10,11) an der Umfangsfläche des Trägersubstrats (1) und das dadurch hervorgerufene Drehmoment das Zentrierelement (10,11) gegen eine Anschlagfläche (73) des Anschlagelementes (69) angedrückt wird.

4. Vorrichtung nach Anspruch 3, **dadurch gekennzeichnet, daß** die Anschlagfläche (73) des wenigstens einen Anschlagelementes (69) in der zweiten Richtung (±x) beweglich gelagert ist.

5. Vorrichtung nach Anspruch 4, **dadurch gekennzeichnet, daß** das wenigstens eine Anschlagelement (69) durch eine zylinderförmige Rolle gebildet wird, die um eine senkrecht zur Aufnahme (30,31) verlaufende Achse (72) an der jeweiligen Verstelleinrichtung (60,61) drehbar gelagert ist und daß die Anschlagfläche (73) durch die Mantelfläche der zylinderförmigen Rolle (69) gebildet wird.

6. Vorrichtung nach einem der Ansprüche 1 oder 2, **dadurch gekennzeichnet, daß** wenigstens eines der Zentrierelemente (10,11,12,13) entgegen der Spannkraft eines Federelements (68) auf seiner jeweiligen Achse (20,21,22,23) verschiebbar angeordnet ist.

7. Vorrichtung nach einem der Ansprüche 1 oder 2, **dadurch gekennzeichnet, daß** der Drehbewegung wenigstens eines der Zentrierelemente (10,11,12,13) um seine jeweilige Achse (20,21,22,23) die Spannkraft eines Federelementes (89) entgegenwirkt.

8. Vorrichtung nach Anspruch 1, **dadurch gekennzeichnet, daß** wenigstens ein Zentrierelement (10,11,12,13) eine ebene Anschlagfläche (40,41,42,43) zur Anlage an der Umfangsfläche (5,6,7,8) des Trägersubstrats (1) aufweist.

9. Vorrichtung nach Anspruch 1 oder 2, **dadurch gekennzeichnet, daß** wenigstens ein Zentrierelemente (10,11,12,13) mittels eines Kugellagers (50,51,52,53) auf den Achsen (20,21, 22,23) drehbar und verschiebbar gelagert ist.

10. Verfahren zur Ausrichtung von Trägerplatten, **dadurch gekennzeichnet, daß** in einer Vorrichtung mit den Merkmalen eines oder mehrerer der Ansprüche 1 bis 7 die Zentrierelemente (10,11,12,13) nacheinander an der Umfangsfläche (5,6,7,8) des Trägersubstrats (1) derart zur Anlage gebracht werden, daß eines der wenigstens zwei weiteren Zentrierelemente (12, 13) zuletzt an der Umfangsfläche zur Anlage gelangt.

## Claims

1. Device for aligning a carrier substrate for electronic circuits, which carrier substrate (1) has two main surfaces (3, 4), which are parallel to one another, and a peripheral surface (5, 6, 7, 8) and is fed with an upwardly facing first main surface (3) to a horizontal receptacle (30, 31) of the device, it being possible for the alignment of the carrier substrate (1) in the horizontal receptacle to use a respective adjusting device (60, 61, 62, 63) to bring centring elements (10, 11, 12, 13) to bear against the peripheral surface of the carrier substrate (1) by means of spring tension, which centring elements (10, 11, 12, 13) displace the carrier substrate in the receptacle into a predetermined position, **characterized in that** at least two centring elements (10, 11) are mounted rotatably and displaceably in the axial direction on a first spindle each (20, 21), which first spindles are oriented parallel to one another and parallel to the horizontal receptacle (30, 31) and are adjustable in relation to the carrier substrate (1) by a respective adjusting device (60, 61) along a first direction (±y), it being possible for the centring elements (10, 11) to be brought to bear against portions (5, 6) of the peripheral surface of the carrier substrate (1) which lie opposite one another in the first direction (±y) by means of a spring tension which is effective in the first direction (±y), and **in that** at least two further centring elements (12, 13) are adjustable in relation to the carrier substrate (1) by a respective further adjusting device (62, 63) along a second direction (±x), running perpendicular to the first direction (±y), which further centring elements (12, 13) can be brought to bear with stop surfaces (42, 43) against portions (7, 8) of the peripheral surface of the carrier substrate (1) which lie opposite one another in the second direction (±x) by means of a spring tension which is effective in the second direction (±x), which stop surfaces (42, 43) are mounted movably in a direction (±z) perpendicular to the horizontal receptacle (30, 31).

2. Device according to Claim 1, **characterized in that** the at least two further centring elements (12, 13) are mounted rotatably and displaceably in the axial direction on at least two second spindles (22, 23) running parallel to one another and perpendicular to the horizontal receptacle (30, 31).

3. Device according to Claim 1, **characterized in that** the first spindles are mounted on their respective adjusting device in a plane beneath a plane defined by the horizontal receptacle (30, 31), **in that** at least one stop element (69) is respectively arranged on the adjusting devices (60, 61), and **in that** the centring element (10, 11) is pressed against a stop surface (73) of the stop element (69) by the bearing of the centring element (10, 11), mounted on the respective first spindle (20, 21), against the peripheral surface of the carrier substrate (1) and by the torque caused as a result.

4. Device according to Claim 3, **characterized in that** the stop surface (73) of the at least one stop element (69) is mounted movably in the second direction (±x).

5. Device according to Claim 4, **characterized in that** the at least one stop element (69) is formed by a cylindrical roller, which is mounted rotatably on the respective adjusting device (60, 61) about a spindle (72) running perpendicular to the receptacle (30, 31), and **in that** the stop surface (73) is formed by the circumferential surface of the cylindrical roller (69).

6. Device according to either of Claims 1 and 2, **characterized in that** at least one of the centring elements (10, 11, 12, 13) is arranged displaceably against the tension of a spring element (68) on its respective spindle (20, 21, 22, 23).

7. Device according to either of Claims 1 and 2, **characterized in that** the rotational movement of at least one of the centring elements (10, 11, 12, 13) about its respective spindle (20, 21, 22, 23) counteracts the tension of a spring element (89).

8. Device according to Claim 1, **characterized in that** at least one centring element (10, 11, 12, 13) has a planar stop surface (40, 41, 42, 43) for bearing against the peripheral surface (5, 6, 7, 8) of the carrier substrate (1).

9. Device according to Claim 1 or 2, **characterized in that** at least one centring element (10, 11, 12, 13) is mounted rotatably and displaceably on the spindles (20, 21, 22, 23) by means of a ball bearing (50, 51, 52, 53).

10. Method for aligning carrier plates, **characterized in that**, in a device with the features of one or more of Claims 1 to 7, the centring elements (10, 11, 12, 13) are brought to bear one after the other against the peripheral surface (5, 6, 7, 8) of the carrier substrate (1) in such a way that one of the at least two further centring elements (12, 13) comes to bear last against the peripheral surface.

## Revendications

1. Dispositif d'alignement d'un substrat de support pour circuits électroniques, lequel substrat de support (1) présente deux surfaces principales (3, 4) parallèles l'une par rapport à l'autre et une surface périphérique (5, 6, 7, 8) et est transféré avec une première surface principale (3) orientée vers le haut vers un logement horizontal (30, 31) du dispositif, avec des éléments de centrage (10, 11, 12, 13) pour l'alignement du substrat de support (1) dans le logement horizontal qui peuvent être appliqués par respectivement un dispositif d'ajustage (60, 61, 62, 53) contre la surface périphérique du substrat de support (1) au moyen d'une force de serrage élastique, lesquels éléments de centrage (10, 11, 12, 13) déplacent le substrat de support dans le logement dans une position préalablement définie,
**caractérisé en ce qu'**
au moins deux éléments de centrage (10, 11) sont logés en rotation sur respectivement un premier axe (20, 21) et mobiles dans le sens axial, lesquels premiers axes sont orientés parallèlement l'un à l'autre et parallèlement au logement horizontal (30, 31) et ajustables par respectivement un dispositif d'ajustage (60, 61) le long d'une première direction (±y) par rapport au substrat de support (1), les éléments de centrage (10, 11) pouvant être appliqués contre des segments (5, 6) de la surface périphérique du substrat de support (1) situés en regard l'un de l'autre dans la première direction (±y) au moyen d'une force de serrage élastique efficace dans la première direction (±y), et au moins deux autres éléments de centrage (12, 13) peuvent être ajustés par respectivement un autre dispositif d'ajustage (62, 63) le long d'une deuxième direction (±x) s'étendant perpendiculairement à la première direction (±y) par rapport au substrat de support (1), lesquels autres éléments de centrage (12, 13) pouvant être appliqués par des surfaces de butée (42, 43) au moyen d'une force de serrage élastique efficace dans la deuxième direction (±x) contre des segments (7, 8) de la surface périphérique du substrat de support (1) situés en regard les uns des autres dans la deuxième direction (±x), les surfaces de butée (42, 43) étant logées mobiles dans une direction (±z) perpendiculaire au logement horizontal (30, 31).

2. Dispositif selon la revendication 1,
**caractérisé en ce que**
les au moins deux autres éléments de centrage (12, 13) sont logés en rotation et déplaçables dans la direction axiale sur au moins deux deuxièmes axes (22, 23) parallèles l'un par rapport à l'autre et s'étendant perpendiculairement au logement horizontal (30, 31).

3. Dispositif selon la revendication 1,
**caractérisé en ce que**
les premiers axes sont montés sur leur dispositif d'ajustage respectif dans un plan situé sous un plan défini par le logement horizontal (30, 31), avec sur les dispositifs d'ajustage (60, 61) respectivement au moins un élément de butée (69), et par l'application de l'élément de centrage (10, 11) logé sur respectivement le premier axe (20, 21) contre la surface périphérique du substrat de support (1) et le couple de rotation ainsi généré, l'élément de centrage (10, 11) est appliqué contre une surface de butée (73) de l'élément de butée (69).

4. Dispositif selon la revendication 3,
**caractérisé en ce que**
la surface de butée (73) de l'au moins un élément de butée (69) est logé de façon mobile dans la deuxième direction (±x).

5. Dispositif selon la revendication 4,
**caractérisé en ce que**
l'au moins un élément de butée (69) est formé par un rouleau cylindrique logé en rotation autour d'un axe (72) s'étendant perpendiculairement au logement (30, 31) sur le dispositif d'ajustage (60, 61) respectif, et la surface de butée (73) est formée par la surface d'enveloppe du rouleau cylindrique (69).

6. Dispositif selon l'une quelconque des revendications 1 ou 2,
**caractérisé en ce qu'**
au moins l'un des éléments de centrage (10, 11, 12, 13) est disposé de façon mobile sur son axe respectif (20, 21, 22, 23) contre la force de serrage d'un élément élastique (68).

7. Dispositif selon l'une quelconque des revendications 1 ou 2,
**caractérisé en ce que**
la force de serrage d'un élément élastique (89) s'oppose au mouvement de rotation d'au moins l'un des éléments de centrage (10, 11, 12, 13) autour de son axe (20, 21, 22, 23) respectif.

8. Dispositif selon la revendication 1,
**caractérisé en ce qu'**
au moins un élément de centrage (10, 11, 12, 13) présente une surface de butée (40, 41, 42, 43) plane pour s'appliquer contre la surface périphérique (5, 6, 7, 8) du substrat de support (1).

9. Dispositif selon la revendication 1 ou 2,
**caractérisé en ce qu'**
au moins un élément de centrage (10, 11, 12, 13) est logé en pivotement et en déplacement sur les axes (20, 21, 22, 23) au moyen d'un roulement à billes (50, 51, 52, 53).

10. Procédé d'alignement de substrat de support,
**caractérisé en ce que**
dans un dispositif présentant les caractéristiques d'une ou de plusieurs des revendications 1 à 7, les éléments de centrage (10, 11, 12, 13) sont appliqués successivement contre la surface périphérique (5, 6, 7, 8) du substrat de support (1) de telle sorte que l'un des au moins deux autres éléments de centrage (12, 13) arrive en dernier en application contre la surface périphérique.
